# EUROPÄISCHE PATENTSCHRIFT

(11) **EP 2 325 949 B1**
(45) Veröffentlichungstag und Bekanntmachung des Hinweises auf die Patenterteilung: **06.07.2016**
(21) Anmeldenummer: 10014694.3
(22) Anmeldetag: 17.11.2010
(51) Int. Cl.: H01R 13/11

(54) **Anschlussvorrichtung für einen elektronischen Stromzähler**
Connecting device for an electonic metering device
Dispositif de connexion pour un compteur électronique d'électricité

(30) Priorität: 19.11.2009 DE 102009053940
(43) Veröffentlichungstag der Anmeldung: 25.05.2011
(73) Patentinhaber: Hager Electro GmbH & Co. KG, 66440 Blieskastel (DE)
(72) Erfinder: Kelaiditis, Konstantin, 66386 St. Ingbert (DE); Zimmermann, Michael, 66130 Saarbrücken (DE)
(74) Vertreter: Nuss, Laurent

(56) Entgegenhaltungen:
- EP-A1- 1 462 808
- EP-A1- 1 586 908
- EP-A1- 1 593 972
- EP-A1- 1 901 398
- EP-A2- 1 901 078
- DE-A1- 10 344 736
- DE-A1-102004 001 453
- DE-A1-102005 021 136
- DE-A1-102007 046 640

## Beschreibung

Die Erfindung betrifft eine Anschlussvorrichtung für einen elektronischen Stromzähler, mit einer den Stromzähler aufnehmenden Tragplatte, die Öffnungen für den Durchtritt vom Stromzähler vorstehender Anschlusskontakte aufweist und hinter der mit den Anschlusskontakten elektrisch verbindbare Anschlussleiter angeordnet sind.

Herkömmliche Stromzähleranschlussvorrichtungen der Elektroinstallation von Gebäuden weisen Anschlussleisten auf, an denen neben Klemmanschlusselementen für Stromkabel zusätzlich Klemmanschlusselemente für den Abgriff von Versorgungsspannungen für Zusatzgeräte vorgesehen sind. Darüber hinaus werden zum Spannungsabgriff mit spannungsführenden Teilen der Anschlussvorrichtung dauerhaft verbundene Anschlussleiter verwendet, die aus einem isolierenden Gehäuse der Anschlussvorrichtung herausgeführt sind.

Anschlussvorrichtungen der eingangs genannten Art gehen aus der DE 10 2004 001 453 A1, der EP 1 586 908 A1, der EP 1 901 398 A1, der EP 1901 078 A2 sowie der EP 1 462 808 A1 hervor. Die Zählertragplatte dieser bekannten Anschlussvorrichtungen weist Öffnungen für den Durchtritt vom Zähler in Richtung der Zählertragplatte vorstehende Anschlusskontakte für drei Stromphasen und den Neutralleiter auf. In entsprechender Anzahl sind Anschlussleiter hinter der Tragplatte vorgesehen. Keines der genannten Dokumente erwähnt einen Spannungsabgriff für eine Spannungsversorgung über den Stromzähler hinaus bei der Anschlussvorrichtung betriebener Zusatzgeräte, wie z.B. Kommunikationsgeräte für die Kommunikation mit dem Stromversorgungsunternehmen.

Das Dokument DE 10 2007 046 640 A1 offenbart eine Anschlussvorrichtung mit einer Tragplatte, die die Anordnung einer in Reihe zu einem Stromzähler geschalteten Sicherungseinrichtung ermöglicht.

Der vorliegenden Erfindung liegt die Aufgabe zugrunde, eine neue Stromzähleranschlussvorrichtung der oben genannten Art zu schaffen, die bei geringem Bauaufwand einen sicheren Spannungsabgriff ermöglicht.

Die diese Aufgabe lösende Anschlussvorrichtung nach der Erfindung ist gekennzeichnet durch Einrichtungen zum Abgreifen einer Spannung für die Spannungsversorgung über den Stromzähler hinaus bei der Anschlussvorrichtung betriebener Zusatzgeräte, wobei die Abgriffseinrichtungen ein Steckerelement umfassen, dass unter Kontaktierung von einem der Anschlussleiter in eine weitere Öffnung in der Tragplatte einsteckbar ist.

Gemäß der Erfindung wird eine Spannung durch eine Einstecköffnung in der Tragplatte hindurch mit Hilfe eines in die Einstecköffnung einführbaren Steckerelements unmittelbar von einem hinter der Tragplatte vorhandenen Anschlussleiter abgegriffen. Über die Einstecköffnung in der Tragplatte hinaus bedarf es an der Tragplatte und den Anschlussleitern für den Spannungsabgriff keiner oder nur geringfügiger baulicher Veränderungen.

Vorzugsweise sind in der Tragplatte zwei Einstecköffnungen zur wahlweisen Kontaktierung eines gezählten oder ungezählten Strom führenden Anschlussleiters durch das Steckerelement vorgesehen. In weiterer Ausgestaltung der Erfindung kann in der Tragplatte auch eine Einstecköffnung zur Kontaktierung eines Neutralanschlussleiters vorgesehen sein, so dass zum Spannungsabgriff die notwendige Verbindung mit dem Neutralleiter in gleicher Weise wie die Kontaktierung der spannungsführenden Anschlussleiter erfolgt.

Zweckmäßig ist in der Tragplatte ein zu der Einstecköffnung führender Nutenkanal für die Aufnahme eines mit dem Steckerelement verbundenen Leiters gebildet.

Der Nutenkanal kann Einrichtungen zum Einrasten des Leiters in dem Nutenkanal aufweisen, z.B. von der Kanalwand vorstehende Rastnasen.

Das Steckerelement kann, wie der Leiter im Nutenkanal, vollständig in der Tragplatte versenkbar sein oder bündig mit der dem Stromzähler zugewandten Oberfläche der Tragplatte abschließen. In beiden Fällen lässt sich der Stromzähler ohne Behinderung durch den Spannungsabgriff auf die Tragplatte aufsetzen.

Das Steckerelement kann einen vorzugsweise in eine Isolierung des damit verbundenen Leiters übergehendes oder daran angespritzten Isolierteil aufweisen.

Vorzugsweise füllt das Isolierteil den zur Plattenebene parallelen Querschnitt der Öffnung in der Tragplatte vollständig aus.

Das Steckerelement umfasst zweckmäßig an dem Anschlussleiter klammerartig angreifende Klemmschenkel, wobei die Klemmschenkel insbesondere an Längsseiten eines abgeflachten Leiterquerschnitts des Anschlussleiters angreifen.

An einer Seite des Anschlussleiters können zwei Klemmschenkel und an der dieser Seite gegenüberliegenden Seite des Anschlussleiters ein Klemmschenkel an dem Anschlussleiter angreifen. Alternativ liegen zwei Klemmschenkel einander gegenüberliegend an dem Anschlussleiter an.

Vorzugsweise ist der Isolierteil gegen einen das Eindringen des Steckerelements in die Einstecköffnung begrenzenden, vorzugsweise mit der Tragplatte verbundenen Anschlag anlegbar. Der Anschlag kann z.B. durch einen Stufenabsatz der Einstecköffnung gebildet sein, in welchen ein von dem Isolierteil seitlich vorstehender Steg eingreift.

Zweckmäßig ist der Isolierteil des Steckerelements in der Einstecköffnung einrastbar.

Als Anschlussleiter für den Spannungsabgriff dient zweckmäßig der in der Mitte zwischen drei nebeneinander vorgesehenen Anschlussleiterpaaren für drei Stromphasen (L1,L2,L3), da im Falle einer einphasigen Ausführung der Anschlussvorrichtung vorzugsweise die beiden äußeren Anschlussleiterpaare (L1,L3) entfallen.

Die Erfindung wird nachfolgend anhand von Ausführungsbeispielen und der beiliegenden, sich auf diese Ausführungsbeispiele beziehenden Zeichnungen weiter erläutert. Es zeigen:
- Fig. 1: eine Stromzähleranschlussvorrichtung in einer Draufsicht mit Spannungsabgriffseinrichtungen nach der Erfindung,
- Fig. 2: eine Teildarstellung der Stromzähleranschlussvorrichtung von Fig. 1,
- Fig. 3: eine Einstecköffnung in einer Zählertragplatte der Stromzähleranschlussvorrichtung von Fig. 1 in einer Draufsicht und einem Schnitt,
- Fig. 4: ein Steckerelement der in Fig. 1 gezeigten Spannungsabgriffseinrichtungen in einer Seitenansicht,
- Fig. 5: das Steckerelement von Fig. 4 in einer Draufsicht,
- Fig. 6: das Steckerelement von Fig. 4 in einer weiteren, zu der Seitenansicht von Fig. 4 um 90 ° gedrehten Seitenansicht,
- Fig. 7: ein metallisches Leiterstück des Steckerelements von Fig. 4 in einer perspektivischen Ansicht,
- Fig. 8: das Leiterstück von Fig. 7 in einer Seitenansicht,
- Fig. 9: das Leiterstück von Fig. 7 in einer weiteren Seitenansicht verbunden mit einem zu einem Verteilerelement führenden Leiter,
- Fig. 10: das Steckerelement von Fig. 4 verbunden mit einem Anschlussleiter der Stromzähleranschlussvorrichtung von Fig. 1 in einer Seitenansicht,
- Fig. 11: die Verbindung von Fig. 10 in einer Draufsicht,
- Fig. 12: die Verbindung von Fig. 10 in einer perspektivischen Ansicht,
- Fig. 13: die Verbindung von Fig. 10 in einer weiteren, zu der Seitenansicht von Fig. 10 um 90 ° gedrehten Seitenansicht,
- Fig. 14: das Steckerelement von Fig. 4 verbunden mit einem weiteren, den Neutralleiter betreffenden Anschlussleiter der Stromzähleranschlussvorrichtung von Fig. 1 in einer Seitenansicht,
- Fig. 15: die Verbindung von Fig. 14 in einer Draufsicht,
- Fig. 16: ein weiteres, in einem Steckerelement nach der Erfindung verwendbares metallisches Leiterstück mit zwei Klemmschenkeln in perspektivischer Ansicht,
- Fig. 17: das Leiterstück von Fig. 16 in einer Seitenansicht,

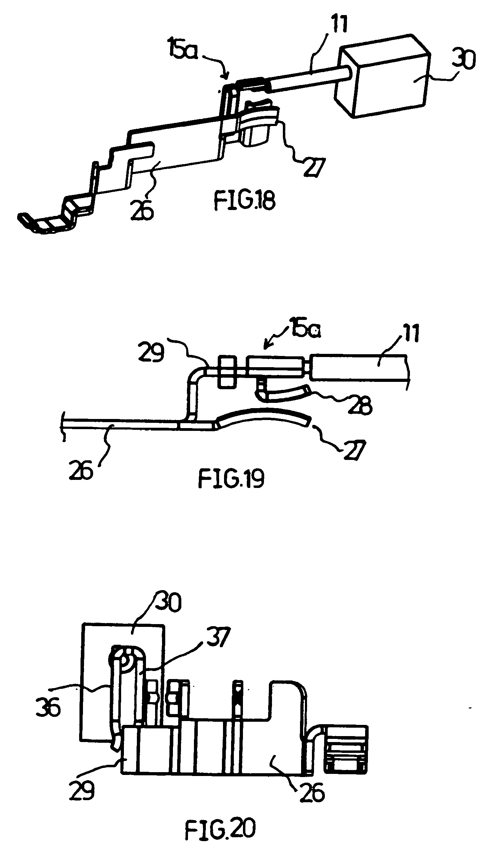

- Fig. 18: das Leiterstück von Fig. 16 verbunden mit einem Anschlussleiter der Stromzähleranschlussvorrichtung von Fig. 1 in perspektivischer Ansicht,
- Fig. 19: die Verbindung von Fig. 18 in einer Draufsicht, und
- Fig. 20: die Verbindung von Fig. 18 in einer Seitenansicht.

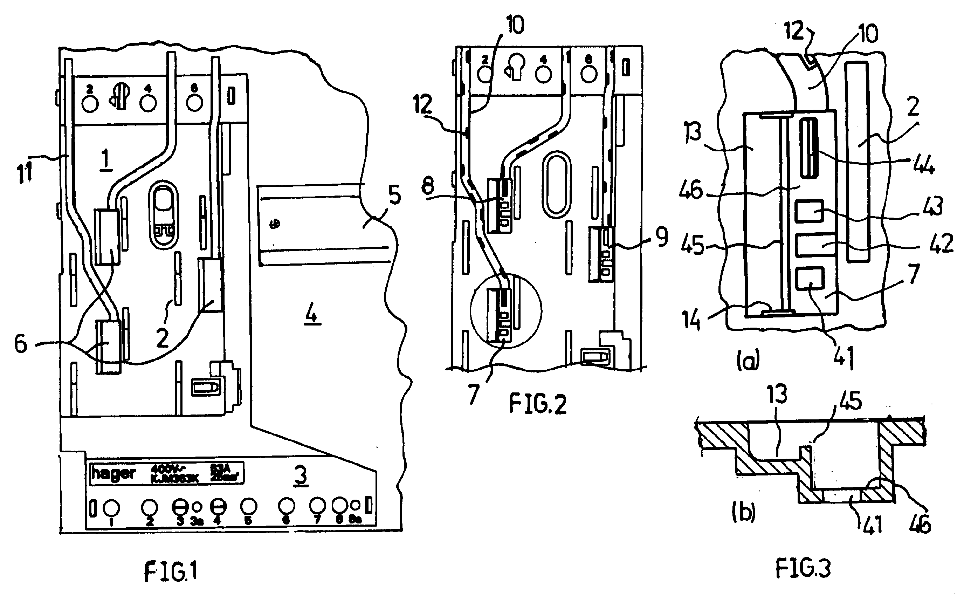

Eine in Fig. 1 gezeigte Stromzähleranschlussvorrichtung umfasst eine den Stromzähler (nicht gezeigt) aufnehmende Tragplatte 1 mit Durchtrittsöffnungen 2 für von dem Stromzähler vorstehende Anschlusskontakte. Durch Aufsetzen des Stromzählers auf die Tragplatte 1 und parallele Verschiebung auf der Tragplatte können die Anschlusskontakte mit hinter der Tragplatte angeordneten, in Fig. 1 nicht sichtbaren Anschlussleitern verbunden werden, die zu einer Anschlussleiste 3 geführt sind. Die Stromzähleranschlussvorrichtung ist in dem gezeigten Ausführungsbeispiel Bestandteil eines eine Grundplatte 4 umfassenden Adapters, der sich am Zählerkreuz eines Anschlussplatzes für einen herkömmlichen elektro-mechanischen Stromzähler anbringen lässt.

Eine Hutprofiltrögerschiene 5 auf der Grundplatte 4 ermöglicht die Installation mit dem Stromzähler verbindbarer Zusatzgeräte, z.B. eines Moduls zur Kommunikation mit einem Stromversorgungsunternehmen.

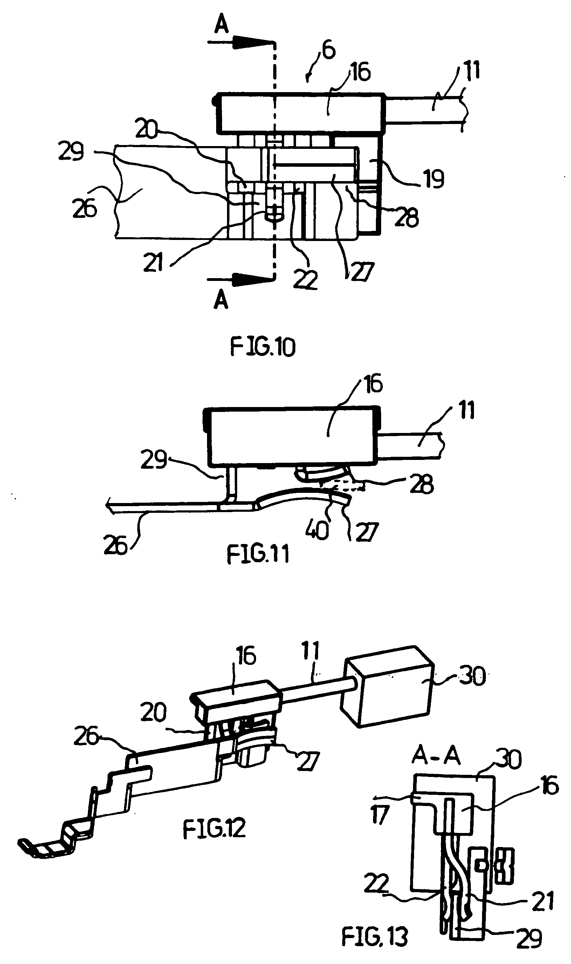

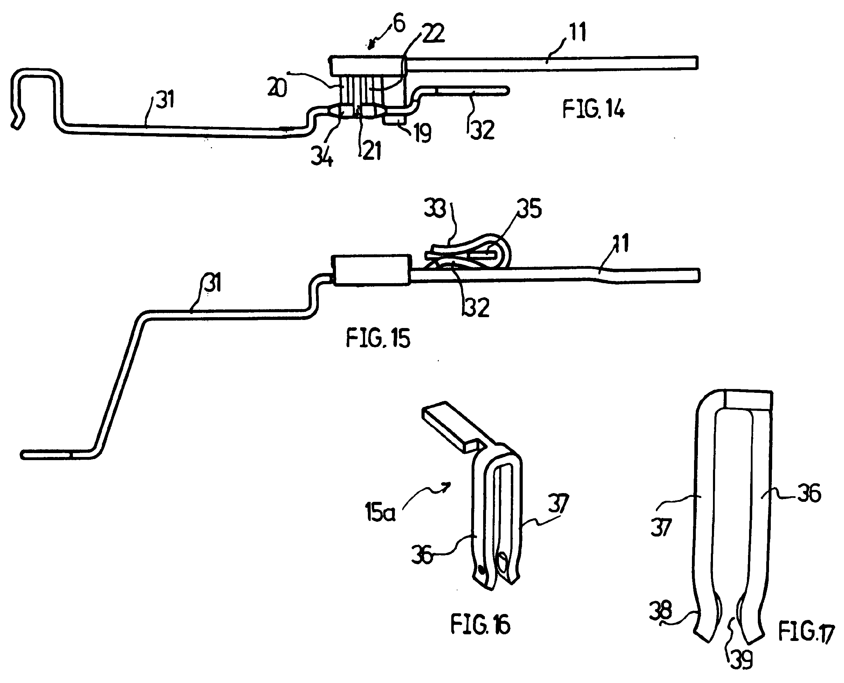

Zur Spannungsversorgung der Zusatzgeräte sind Spannungsabgriffseinrichtungen vorgesehen, die weitere Öffnungen in der Zählertragplatte umfassen, in welche jeweils ein Steckerelement 6 zur Verbindung mit einem hinter der Tragplatte 1 verlaufenden Anschlussleiter 26 (Fig. 10) oder 31 (Fig. 14) einführbar ist.

Wie insbesondere aus Fig. 2 hervorgeht, sind in dem gezeigten Ausführungsbeispiel drei weitere Öffnungen 7 bis 9 vorgesehen, von denen die Öffnung 7 dem Spannungsabgriff von einem ungezählten Strom führenden Anschlussleiter (L2), die Öffnung 8 dem Spannungsabgriff von einem gezählten Strom führenden Anschlussleiter (I2) und die Öffnung 9 der Kontaktierung eines hinter der Tragplatte 1 verlaufenden, einen Neutralleiter bildenden Anschlussleiter 31 (Fig. 14) dient.

Von den Öffnungen 7 bis 9 verläuft jeweils ein in der Tragplatte 1 gebildeter Nutenkanal 10 für die Aufnahme mit dem betreffenden Steckerelement 6 verbundener Leiter 11. Vorsprünge 12 in den Nutenkanölen 10 ermöglichen ein Einrasten der Leiter 11 in den Nutenkanälen.

In den rechteckigen, einen Boden 46 aufweisenden Öffnungen 7 bis 9 ist jeweils ein Stufenabsatz 13 gebildet, an dessen Längsenden am Öffnungsrand je eine Rastnase 14 vorgesehen ist. Der Boden 46 weist Durchgänge 41 bis 44 auf. Eine Randerhöhung 45 begrenzt auf einer Seite den Stufenabsatz 13, wie dies insbesondere Fig. 3b erkennen lässt.

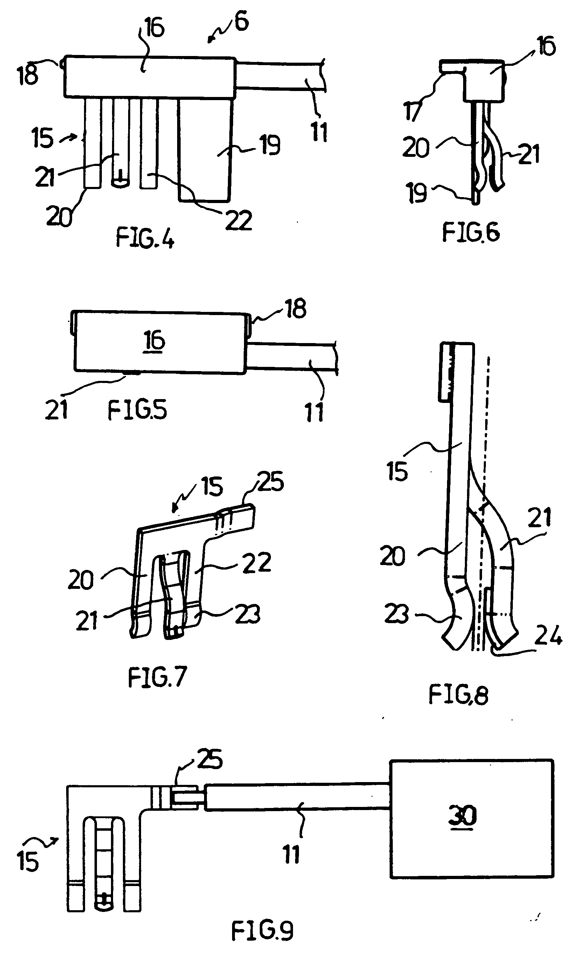

Das in den Figuren 7 bis 8 gesondert dargestellte Steckerelement 6 weist neben einem metallischen Leiterstück 15 einen Isolierteil 16 auf, in den das Leiterstück 15 teilweise eingebettet ist und der in eine Isolierung des an das Steckelement angeschlossenen Leiters 11 übergeht oder an diese angespritzt ist.

Der Isolierteil 16 weist einen seitlich vorstehenden Steg 17 (Fig. 6) zum Eingriff in den Stufenabsatzes 13 auf, wobei an den Längsenden des Steges den Rastvorsprüngen 14 entsprechende Gegenvorsprünge 18 gebildet sind. In Richtung des Leiterstücks 15 steht von dem Isolierteil 16 ein einstückig mit dem Isolierteil verbundenes Führungsschwert 19 vor.

Das Leiterstück 15 umfasst in dem gezeigten Ausführungsbeispiel drei Klemmschenkel 20 bis 22 mit jeweils gerundeten Kontaktabschnitten 23 am freien Ende. Der Klemmschenkel 21 ist von den übrigen Klemmschenkeln 20,22 seitlich abgespreizt, wie insbesondere Fig. 8 erkennen lasst, und weist am gerundeten Kontaktabschnitt einen vorstehenden Kontaktkamrn 24 auf.
Wie aus Fig. 9 hervorgeht, ist ein gegen die Klemmschenkel 20 bis 22 um 90 ° abgewinkeltes Anschlussstück 25 des Leiterstücks 15 mit dem isolierten Leiter 11 verbunden. Der isolierte Leiter 11 führt zu einem Element 30 mit einem oder mehreren (nicht gezeigten) Spannungsabgriffen, wie z.B. Steck- oder Klemmanschlüssen.

Ein Ausführungsbeispiel für die oben erwähnte Verbindung des Steckerelements 6 mit einem gezählten oder ungezählten Strom führenden, hinter der Tragplatte 1 angeordneten Anschlussleiter geht aus den Figuren 10 bis 13 hervor.

Ein im Wesentlichen aus einem Blechstreifen gebildeter Anschlussleiter 26 weist zungenartige Kontaktschenkel 27 und 28 zur Verbindung mit einem Anschlusskontakt 40 des ansonsten nicht gezeigten Stromzählers auf.

Der Anschlussleiter 26 ist in Bezug auf die betreffende Öffnung in der Tragplatte 1 derart angeordnet, dass die Klemmschenkel 20 bis 22 des durch diese Öffnung eingeführten Steckerelements 6 einen tiefer als der Kontaktschenkel 27 liegenden Abschnitt des Kontaktschenkels 28 zwischen sich einklemmen, wobei die Klemmschenkel 20 und 22 des Steckerelements 6 auf einer Seite des Abschnitts 29 und der Klemmschenkel 21 auf der anderen Seite des Abschnitts 29 angeordnet ist, wie insbesondere Fig. 10 und 13 erkennen lassen. Die tiefer liegende Position des Abschnitts 29 ermöglicht verhältnismäßig lange, ausschließlich elastisch bequem aufspreizbare Klemmschenkel 20 bis 22.

Ein Ausführungsbeispiel für die oben erwähnte Kontaktierung des Neutralleiters zeigen die Figuren 14 bis 15.

Ein aus einem Drahtstück gebildeter, als Neutralleiter dienender Anschlussleiter 31 weist zungenartige Kontaktschenkel 32,33 für die Verbindung mit einem NeutralleiterKontaktelement 35 des im Übrigen nicht gezeigten Stromzählers auf. Nahe den Kontaktschenkeln 32,33 ist an dem den Anschlussleiter 31 bildenden Draht eine Abflachung 34 gebildet.
Die in Fig. 2 gezeigte Öffnung 9 in der Tragplatte 1 ist so angeordnet, dass die Klemmschenkel 20 bis 22 des in die Einstecköffnung 9 eingeführten Steckerelements 6 den Anschlussleiter 31 im Bereich der Abflachung 34 zwischen sich einschließen. Zum Abgreifen einer Spannung sind neben der für die Kontaktierung des Neutralleiters vorgesehenen Öffnung 9 wahlweise die Öffnungen 7 oder 8 zu nutzen, je nachdem ob Zusatzgeräte mit gezähltem oder ungezähltem Strom betrieben werden sollen. Die in die jeweiligen Öffnungen 7 bis 9 eingeführten winkelartigen Steckerelemente 6, deren Klemmschenkel 20 bis 22 durch die Durchgänge 41 bis 43 und deren Führungsschwert 19 durch den jeweiligen Durchgang 44 im Boden 46 tritt, schließen bündig mit der Oberfläche der Tragplatte 1 ab, wobei der Steg 17 des Isolierstücks 16 jeweils in den Stufenabsatz 13 in den Öffnungen eingreift. Die Gegenvorsprünge 18 an dem Isolierteil 16 rasten hinter den Rastvorsprüngen 14 am Öffnungsrand der Öffnungen ein. Die mit den Steckerelementen 6 verbundenen Leiter 11 sind vollständig in den Nutenkanälen 10 der Tragplatte 1 versenkbar und in diesen einrastbar. Die Abmessungen der Durchgänge 41 bis 44 können so bemessen sein, dass die Stromzähleranschlussvorrichtung eine gewünschte Schutznorm erfüllt und zur Bedienung keinen hohen Qualifikationsgrad erfordert. Durch die Randerhöhung 45 des Stufenabsatzes 13 wird zwischen dem seitlich vorstehenden Steg 17 des Isolierteils 16 und dem Stufenabsatz 13 ein zum Lösen der Steckerverbindung durch ein Werkzeug nutzbarer Zwischenraum freigeschalten.

Figur 16 und 17 zeigen eine alternative Ausführungsform für ein in einem Steckerelement verwendbares Leiterstück.

Ein Leiterstück 15a weist im Unterschied zu dem Leiterstück 15 (Fig. 7) nicht drei sondern nur zwei Klemmschenkel 36 und 37 auf, die einander gegenüberliegen. Beide Klemmschenkel sind in einem gerundeten Kontaktabschnitt 38 mit einem Kontaktierungsvorsprung 39 versehen. Im Unterschied zu dem Leiterstück 15 liegen die an verschiedenen Seiten des Abschnitts 29 des Anschlussleiters 26 angreifenden Klemmschenkel 36,37 einander gegenüber.

## Patentansprüche

1. Anschlussvorrichtung für einen elektronischen Stromzähler, mit einer den Stromzäher aufnehmenden Tragplatte (1), die Öffnungen (2) für den Durchtritt vom Stromzähler vorstehender Anschlusskontakte (35,40) aufweist und hinter der mit den Anschlusskontakten (35,40) elektrisch verbindbare Anschlussleiter (26,31) angeordnet sind,
**gekennzeichnet durch** Einrichtungen zum Abgreifen einer Spannung für die Spannungsversorgung über den Stromzähler hinaus bei der Anschlussvorrichtung betriebener Zusatzgeräte, wobei die Abgriffseinrichtungen ein Steckerelement umfassen, dass unter Kontaktierung von einem der Anschlussleiter (26,31) in eine weitere Öffnung (7-9) in der Tragplatte (1) einsteckbar ist.

2. Anschlussvorrichtung nach Anspruch 1,
**dadurch gekennzeichnet,**
**dass** in der Tragplatte (1) zwei Einstecköffnungen (7,8) zur wahlweisen Kontaktierung eines gezählten oder ungezählten Strom führenden Anschlussleiters (26) durch das Steckerelement (6) vorgesehen sind.

3. Anschlussvorrichtung nach Anspruch 1 oder 2,
**dadurch gekennzeichnet,**
**dass** in der Tragplatte (1) eine Einstecköffnung (9) für ein weiteres, einen Neutralanschlussleiter (31) kontaktierendes Steckerelement (6) vorgesehen ist.

4. Anschlussvorrichtung nach einem der Ansprüche 1 bis 3,
**dadurch gekennzeichnet,**
**dass** in der Tragplatte (1) ein zu der Einstecköffnung (7-9) führender Nutenkanal (10) für die Aufnahme eines mit dem Steckerelement (6) verbundenen Leiters (11) gebildet ist.

5. Anschlussvorrichtung nach Anspruch 4,
**dadurch gekennzeichnet,**
**dass** der Nutenkanal (10) Einrichtungen (12) zum Einrasten des Leiters (11) in dem Nutenkanal (10) aufweist.

6. Anschlussvorrichtung nach einem der Ansprüche 1 bis 5,
**dadurch gekennzeichnet,**
**dass** das Steckerelement (6) vollständig in die Tragplatte (1) versenkbar ist oder bündig mit der dem Stromzähler zugewandten Oberfläche der Tragplatte (1) abschließt.

7. Anschlussvorrichtung nach einem der Ansprüche 1 bis 6,
**dadurch gekennzeichnet,**
**dass** das Steckerelement einen vorzugsweise in eine Isolierung des Leiters (11) übergehenden oder an den Leiter (11) angespritzten Isolierteil (16) aufweist.

8. Anschlussvorrichtung nach Anspruch 7,
**dadurch gekennzeichnet,**
**dass** der Isolierteil (16) der zur Tragplatte (1) parallelen Querschnitt der Öffnung (7-9) vollständig ausfüllt.

9. Anschlussvorrichtung nach einem der Ansprüche 1 bis 8,
**dadurch gekennzeichnet,**
**dass** das Steckerelement (6) an dem Anschlussleiter (26) klammerartig angreifende Klemmschenkel (20-22;36,37) umfasst.

10. Anschlussvorrichtung nach Anschluss 9,
**dadurch gekennzeichnet,**
**dass** die Klemmschenkel (20-22;36,37) an den Längsseiten eines flachen Leiterquerschnitts angreifen.

11. Anschlussvorrichtung nach Anspruch 9 oder 10,
**dadurch gekennzeichnet,**
**dass** an einer Seite des Anschlussleiters (26) zwei Leiterschenkel (20,22) und an der dieser Seite gegenüberliegenden Seite des Anschlussleiters (26) ein Leiterschenkel (21) an dem Anschlussleiter (26) angreifen.

12. Anschlussvorrichtung nach einem der Ansprüche 7 bis 11,
**dadurch gekennzeichnet,**
**dass** der Isolierteil (16) gegen einen das Eindringen des Steckerelements (6) in die Einstecköffnung (7-9) begrenzenden, vorzugsweise mit der Tragplatte verbundenen Anschlag (13, 41) anlegbar ist.

## Claims

1. Connecting device for an electronic metering device, with a support plate (1) mounting the metering device, which support plate comprises openings (2) for the passage of terminal contacts (35, 40) projecting from the metering device and behind which connection leads (26, 31) are arranged which are electrically connectable to the terminal contacts (35, 40), **characterised by** devices for tapping a voltage for the supply of voltage to additional devices operated beyond the metering device with the connecting device,
wherein the tapping devices comprise a connector element which can be inserted into an additional opening (7-9) in the support plate (1) by contacting one of the connection leads (26, 31).

2. Connecting device according to claim 1,
**characterised in that**
in the support plate (1) two insertion openings (7, 8) are provided for the optional contact of a connecting lead (26) carrying counted or uncounted current through the connector element (6).

3. Connecting device according to claim 1 or 2,
**characterised in that**
in the support plate (1) an insertion opening (9) is provided for an additional connector element (6) contacting a neutral connecting lead (31).

4. Connecting device according to any one of claims 1 to 3,
**characterised in that**
in the support plate (1) a groove channel (10) leading to the insertion opening (7-9) is formed for receiving a lead (11) connected to the connector element (6).

5. Connecting device according to claim 4,
**characterised in that**
the groove channel (10) comprises devices (12) for locking the lead (11) into the groove channel (10).

6. Connecting device according to any one of claims 1 to 5,
**characterised in that**
the connector element (6) can be sunk completely into the support plate (1) or ends flush with the surface of the support plate (1) facing the metering device.

7. Connecting device according to any one of claims 1 to 6,
**characterised in that**
the connector element comprises an insulating part (16) which preferably passes into an insulation of the lead (11) or is injected onto the lead (11).

8. Connecting device according to claim 7,
**characterised in that**
the insulating part (16) completely fills the cross-section of the opening (7-9) parallel to the support plate (1).

9. Connecting device according to any one of claims 1 to 8,
**characterised in that**
the connector element (6) on the connection lead (26) comprises clamp-like engaging clamping arms (20-22; 36, 37).

10. Connecting device according to claim 9,
**characterised in that**
the clamping arms (20-22; 36, 37) engage on the longitudinal sides of a flat lead cross-section.

11. Connecting device according to claim 9 or 10,
**characterised in that**
on one side of the connection lead (26) two lead arms (20, 22) engage and on the side of the connection lead (26) opposite said side one lead arm (21) engages with the connection lead (26).

12. Connecting device according to any one of claims 7 to 11,
**characterised in that**
the insulating part (16) can be placed against a stop (13, 41) which limits the penetration of the connector element (6) into the insertion opening (7-9) and is preferably connected to the support plate.

## Revendications

1. Dispositif de connexion pour un compteur d'électricité électronique, comprenant une plaque de support (1) recevant le compteur d'électricité, qui présente des ouvertures (2) pour le passage de contacts de connexion (35, 40) faisant saillie du compteur d'électricité et derrière laquelle sont disposés des conducteurs de connexion (26, 31) pouvant être reliés électriquement aux contacts de connexion (35, 40),
**caractérisé par** des moyens pour prélever une tension pour l'alimentation électrique d'appareils supplémentaires alimentés par le dispositif de connexion au-delà du compteur d'électricité, les moyens de prélèvement comprenant un élément enfichable qui peut être enfiché dans une autre ouverture (7-9) de la plaque de support (1) en établissant le contact avec un des conducteurs de connexion (26, 31).

2. Dispositif de connexion selon la revendication 1,
**caractérisé en ce**
**que** deux ouvertures d'enfichage (7, 8) pour l'établissement du contact au choix avec un conducteur de connexion (26) conduisant un courant compté ou non compté au moyen de l'élément d'enfichage (6) sont prévues dans la plaque de support (1).

3. Dispositif de connexion selon la revendication 1 ou la revendication 2,
**caractérisé en ce**
**qu'**une ouverture d'enfichage (9) pour un autre élément d'enfichage (6) établissant le contact avec un conducteur de connexion neutre (31) est prévue dans la plaque de support (1).

4. Dispositif de connexion selon l'une des revendications 1 à 3,
**caractérisé en ce**
**qu'**un conduit à rainure (10) conduisant vers l'ouverture d'enfichage (7-9), pour la réception d'un conducteur (11) relié à l'élément d'enfichage (6), est formé dans la plaque de support (1).

5. Dispositif de connexion selon la revendication 4,
**caractérisé en ce**
**que** le conduit à rainure (10) présente des moyens (12) pour l'encliquetage du conducteur (11) dans le conduit à rainure (10).

6. Dispositif de connexion selon l'une des revendications 1 à 5,
**caractérisé en ce**
**que** l'élément d'enfichage (6) est complètement encastrable dans la plaque de support (1) ou se termine en affleurement avec la surface de la plaque de support (1) tournée vers le compteur d'électricité.

7. Dispositif de connexion selon l'une des revendications 1 à 6,
**caractérisé en ce**
**que** l'élément d'enfichage présente une partie isolante (16) se transformant de préférence en une isolation du conducteur (11) ou moulée par injection sur le conducteur (11).

8. Dispositif de connexion selon la revendication 7,
**caractérisé en ce**
**que** la partie isolante (16) remplit complètement la section transversale de l'ouverture (7-9) parallèle à la plaque de support (1).

9. Dispositif de connexion selon l'une des revendications 1 à 8,
**caractérisé en ce**
**que** l'élément d'enfichage (6) comprend des branches de serrage (20-22 ; 36, 37) agissant à la manière d'une pince sur le conducteur de connexion (26).

10. Dispositif de connexion selon la revendication 9,
**caractérisé en ce**
**que** les branches de serrage (20-22 ; 36, 37) agissent sur les grands côtés d'une section transversale de conducteur plat.

11. Dispositif de connexion selon la revendication 9 ou la revendication 10,
**caractérisé en ce**
**que**, sur un côté du conducteur de connexion (26), deux branches de conducteur (20, 22) et, sur le côté du conducteur de connexion (26) opposé à ce côté, une branche de conducteur (21) agissent sur le conducteur de connexion (26).

12. Dispositif de connexion selon l'une des revendications 7 à 11,
**caractérisé en ce**
**que** la partie isolante (16) peut être appliquée contre une butée (13, 41) limitant la pénétration de l'élément d'enfichage (6) dans l'ouverture d'enfichage (7-9), de préférence reliée à la plaque de support.
